# EUROPEAN PATENT SPECIFICATION

(11) **EP 0 628 996 B1**
(45) Date of publication and mention of the grant of the patent: **12.05.1999**
(21) Application number: 94903045.6
(22) Date of filing: 24.12.1993
(51) Int. Cl.: H01L 29/732, H01L 29/10

(54) **High withstand-voltage semiconductor device with dielectric isolation**
Halbleiterbauelement mit hoher Spannungsfestigkeit und dielektrischer Isolierung
Dispositif semi-conducteur à tenue en tension élevée et à isolement diélectrique

(30) Priority: 25.12.1992 JP 346414/92; 02.02.1993 JP 15338/93
(43) Date of publication of application: 14.12.1994
(73) Proprietor: DENSO CORPORATION, Kariya-City, Aichi-Pref. (JP)
(72) Inventor: MIURA, Shoji, Kariya-city, Aichi-Pref. 448 (JP); IIDA, Makio, Kariya-city, Aichi-Pref. 448 (JP); SUGISAKA, Takayuki, Kariya-city, Aichi-Pref. 448 (JP); SAKAKIBARA, Toshio, Kariya-city, Aichi-Pref. 448 (JP); ISHIHARA, Osamu, Kariya-city, Aichi-Pref. 448 (JP)
(74) Representative: Winter, Brandl, Fürniss, Hübner, Röss, Kaiser, Polte, Kindermann Partnerschaft
(86) International application number: JP9301866
(87) International publication number: WO9415360

(56) References cited:
- WO-A-91/11028
- JP-A- 2 058 864
- JP-A- 3 116 877
- JP-A- 4 186 746
- JP-A-61 048 968
- JP-A-63 236 343
- PATENT ABSTRACTS OF JAPAN vol. 15 no. 308 (E-1097) ,7 August 1991 & JP-A-03 110852 (NIPPONDENSO CO LTD) 10 May 1991,

## Description

### TECHNICAL FIELD

The present invention generally relates to a semiconductor device. More particularly, the present invention relates to a high withstand voltage type semiconductor device which is dielectrically isolated at least at the sides thereof.

### BACKGROUND ART

In a semiconductor device to be loaded on a vehicle, such as a microcomputer for controlling the vehicle engine used in a high noise environment, the first priority should be given to the withstand voltage despite some disadvantages therefore, such as the slight degradation of the integration degree or an increase in the number of manufacturing processes. This purpose is most suitably served by a transistor integrated circuit of side dielectric isolation structure or total (side and bottom) dielectric isolation structure (as disclosed in the Japanese Unexamined Patent Publication No. 48-100081).

An example of high withstand voltage type NPN bipolar transistors of total dielectric isolation structure is illustrated in FIG. 27. In this figure, reference number 3 denotes a buried collector region; 101, a low concentration collector withstand voltage region; 102, a high concentration base region; 103, an emitter region; 100, a bottom dielectric isolation oxide film; and 104, a side dielectric isolation oxide film.

In this bipolar transistor, as a high voltage is applied to between the base region 102 and the buried collector region 3, a base/collector junction J is subjected to a strong reverse bias, and a depletion layer DL (not illustrated) thereof greatly extends into the collector withstand voltage region 101 engulfing the base region 102.

In the high withstand voltage semiconductor device of the above structure, it is so designed that depletion layer DL in the base/collector junction J can not reach the buried collector region 3. Similarly, it is also designed that the base region 102 is sufficiently separated from the side dielectric isolation oxide film 104 so as not to allow the depletion layer DL to reach the side isolation oxide film 104.

The depletion layer DL in the base/collector junction J is designed as to be separated from the buried collector region 3. One of the reasons for this arrangement in design is that the contact of the depletion layer DL in the base/collector junction J (corresponding to the gate/drain junction of power MOSFET) with the buried collector region 3 (corresponding to the drain area of power MOSFET) would have an effect on the collector current due to a change in the collector voltage when the transistor is switched ON.

Another reason for the above design arrangement is that an increase in the reverse bias voltage between the base and the collector after the arrival of the depletion layer DL in the buried collector region would allow the depletion layer DL to extend to the base side, causing an increase in the base resistance, i.e., leading to a change in the electric characteristics and ending up in a punch through phenomena between the emitter and the collector.

On the other hand, the depletion layer DL in the base/collector junction J is designed as to be separated from the side dielectric isolation oxide film 104. One of the reasons for this design arrangement is that the formation of a transistor similar to the above transistor in a conduction region (not illustrated) which is in contact with the depletion layer DL through the side dielectric isolation oxide film 104 would cause the withstand voltage characteristics of the transistor to be degraded due to the effect of the electric potential at the conductive region on the profile of the depletion layer DL.

Nevertheless, higher withstand voltage performance is required for the above conventional high withstand transistor.

Of course, the lower the concentration of impurities in the collector withstand voltage region 101 is, the wider the depletion layer DL is, and the higher the withstand voltage performance is. However, in order to prevent the extension of the depletion layer DL to the side dielectric isolation oxide film 104 and/or the buried collector region 3 due to the expansion of the depletion layer DL, the collector withstand voltage region 101 should be expanded in lateral width and depth. The increase in the lateral width and depth of the collector withstand voltage region 101, however, would degrade the integration degree of the transistor.

Patent Abstract of Japan 13(38), (E-709)[3386] and JP-A-63236343 disclose a semiconductor device having a walled emitter structure. A formation of an inversion layer occurs at the interface of an isolation film and a base region between emitter and collector. In order to prevent the formation of the inversion layer a polycrystalline silicon layer provided with a stabilised potential (ground potential) is formed on an oxide insulating film formed on a groove. A base region is in contact with the oxide insulating film. The formation of the groove normally results in crystal defects in a semiconductor region adjacent to the groove. Crystal defects in a pn junction between the base region and a collector region lead to a leak current and a variation of resistance of the respective semiconductor region.

Patent Abstract of Japan 15(315), (E-1099) [4843] and JP-A-3116877 disclose a high breakdown strength semiconductor device formed in an insulated semiconductor region. In a first case an n⁺ region (high potential) is disposed outside of a p⁺ region (low potential) in an n⁻ region (island). In this case a depletion layer extending from the interface of an SiO₂ film and an n⁻ region, a depletion layer extending from the interface of the SiO₂ film and the n⁻ region, and a depletion layer extending from the pn junction of the p⁺ region and the n⁻ region are connected to obtain a high breakdown strength by sharing an electric field intensity by means of second SiO₂ films and connected depletion layers. The depletion layer extending from the pn junction of the p⁺ region and the n⁻ region is neither deformed, nor does it reach a side dielectric isolation region, i.e. the concentration of the electric field intensity at the curvature portion of the depletion layer from the pn junction is not considered. In a second case a p⁺ region (low potential) is disposed outside of a first n⁺ region (high potential) in a first n⁻ region (island). In this case a second n⁺ region which decreases the breakdown strength due to the avalanche breakdown caused at the interface of the second n⁺ region and a second n⁻ region surrounds the first n⁻ region. Therefore, the depletion layer extending from the pn junction cannot reach the side dielectric isolation region because of the provision of the second n⁺ region. Additionally, in this case a polysilicon or an adjacent region is provided to which a fixed electric potential is applied. Therefore, the depletion layer extending from the pn junction is neither deformed, nor does it reach the side dielectric isolation region. The breakdown strength is improved by cutting off the depletion layer extending from the pn junction from the communication between the second n⁺ region and the first n⁺ region.

Documents WO-A-9111028 and Patent Abstracts of Japan 16(505), (E-1281) [5548] and JP-A-4186746 teach the provision of polysilicon regions which surround an element region.

In view of the above, it is an object of the present invention to provide an semiconductor device which can compatibly improve both the withstand voltage performance and the integration degree. The object is solved by the measures indicated in claim 1.

### DISCLOSURE OF THE INVENTION

The present invention is described as arrangement that voltage, which allows a depletion layer between a semiconductor layer within an element region and an islandish semiconductor region to reach a side dielectric isolation region, is applied between the semiconductor layer and the islandish semiconductor region, and a semiconductor region adjacent thereto has an electric potential which is more approximate to that at the islandish semiconductor region than to that at the element region.

In the above composition according to the present invention a, PN junction between the semiconductor layer within the element region and the islandish semiconductor region is subjected to reverse bias, and the depletion layer thereof reaches the side dielectric isolation region.

Here, the semiconductor region adjacent to the semiconductor layer within the element region with the side dielectric isolation region therebetween has an electric potential approximate to that at the islandish semiconductor region rather than to that at the semiconductor layer within the element region.

As a result, the electric potential within the adjacent semiconductor region exerts an electrostatic effect on the depletion layer adjacent to the side dielectric isolation region therethrough, deforming the depletion layer between the islandish semiconductor region and the side dielectric isolation region.

In this case, as the electric potential at the adjacent semiconductor region is set to be approximate to that at the islandish semiconductor region rather than to that at the semiconductor layer within the element region, the above depletion layer is subjected to the effect of the electric potential from both the islandish semiconductor region and the adjacent semiconductor region. This mitigates the concentration of the electric field in the vicinity of a corner part between the side and bottom of the islandish semiconductor region, restraining the avalanche breakdown at the corner part.

As the withstand voltage of this semiconductor device is dependent on the above avalanche breakdown at the corner part of the surface semiconductor region, the withstand voltage is improved when the avalanche breakdown is restrained. Furthermore, as the above depletion layer can be used in a position where the depletion later is in contact with the side dielectric isolation region, superb results can be achieved, such as the narrowed width of the semiconductor withstand voltage region and the raised integration degree.

### BRIEF DESCRIPTION OF DRAWINGS

FIG. 1 is a cross-sectional view illustrating a semiconductor device according to the first embodiment;
FIG. 2 is a plane view of FIG. 1;
FIG. 3 is a cross-sectional view illustrating a manufacturing process for the semiconductor device according to the first embodiment;
FIG. 4 is a cross-sectional view illustrating a manufacturing process for the first embodiment;
FIG. 5 is a cross-sectional view illustrating a manufacturing process for the first embodiment;
FIG. 6 is a cross-sectional view illustrating a manufacturing process for the first embodiment;
FIG. 7 is a cross-sectional view illustrating a manufacturing process for the first embodiment;
FIG. 8 is a cross-sectional view illustrating a manufacturing process for the first embodiment;
FIG. 9 is a plane view illustrating a model of the semiconductor device used for simulation;
FIG. 10 is a cross-sectional view illustrating the profile of a depletion layer formed in the semiconductor device according to the first embodiment;
FIG. 11 is a cross-sectional view illustrating the profile of a depletion layer formed in the semiconductor device according to the first embodiment;
FIG. 12 is a cross-sectional view illustrating the profile of a depletion layer formed in the semiconductor device according to the first embodiment;
FIG. 13 is a cross-sectional view illustrating the profile of a depletion layer formed in the semiconductor device according to the first embodiment;
FIG. 14 is a characteristic diagram illustrating the results of the simulation of the relation between the withstand voltage and distance of the semiconductor device according to the first embodiment;
FIG. 15 is a characteristic diagram illustrating the results of the calculation of the relation between the maximum electric field intensity and distance of the semiconductor device according to the first embodiment;
FIG. 16(a) and FIG. 16(b) are characteristic diagrams illustrating the results of the measurements of the relation between the withstand voltage and distance of the semiconductor according to the first embodiment;
FIG. 17 is a cross-sectional view of a semiconductor device according to the second embodiment;
FIG. 18 is a cross-sectional view of a semiconductor device according to the third embodiment;
FIG. 19 is a plane view illustrating the semiconductor device according to the third embodiment;
FIG. 20 is a cross-sectional view of a semiconductor device according to the fourth embodiment;
FIG. 21 is a plane view of the semiconductor device according to the fourth embodiment;
FIG. 22 is a cross-sectional view of a semiconductor device according to the fifth embodiment;
FIG. 23 is a characteristic diagram illustrating the results of the calculation of the relation between the withstand voltage and distance of the semiconductor devices according to the first and fifth embodiments;
FIG. 24 is a cross-sectional view illustrating a semiconductor device according to the sixth embodiment;
FIG. 25 is a cross-sectional view illustrating a semiconductor device according to the seventh embodiment;
FIG. 26 is a top view illustrating the semiconductor device according to the seventh embodiment; and
FIG. 27 is a cross-sectional view illustrating a conventional bipolar transistor.

### Description of preferred embodiments

### (First Embodiment)

A high withstand voltage NPN bipolar transistor of total dielectric isolation structure will now be described as a first embodiment of a semiconductor device according to the present invention.

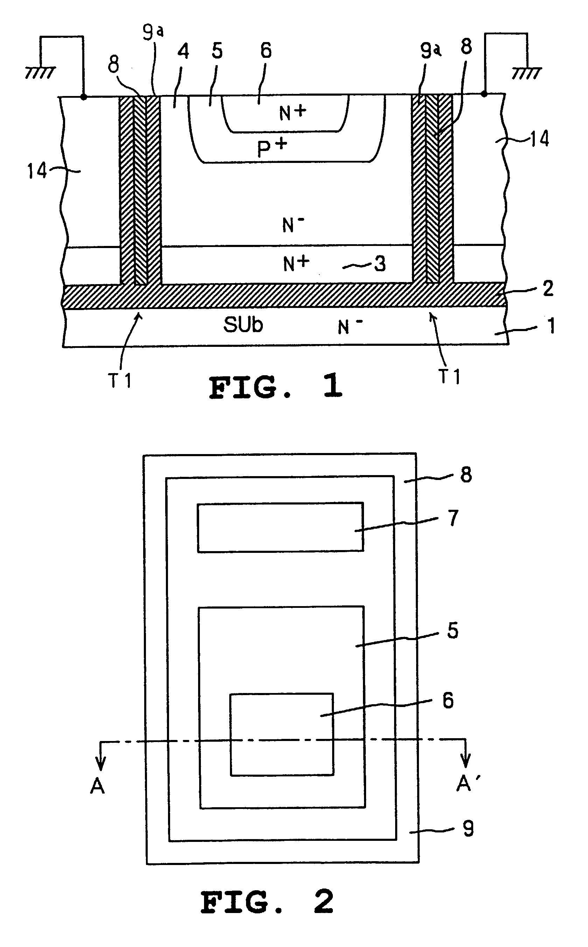

FIG. 1 is a cross-sectional view taken along line A-A' in FIG. 2 which is a top view illustrating this embodiment. In FIG. 1, reference number 1 denotes an N⁻ silicon substrate (substrate); 2, a bottom silicon oxide film for bottom dielectric isolation (bottom dielectric isolation region); 3, an N⁺ buried collector region (high concentration semiconductor layer); 4, an N⁻ collector withstand voltage region (low concentration semiconductor layer); 5, P⁺ base region (islandish semiconductor region); 6, N⁺ emitter region; 8, a polysilicon trench filled region for trench filling (polysilicon region); 9a, a side silicon oxide film (side dielectric isolation region); and 14, a circumferential semiconductor region (adjacent semiconductor region) which is grounded. Reference number 7 in FIG. 2 denotes an N⁺ surface collector region. In FIG. 1, a region in which the polysilicon trench filled region 8 is caught between the side silicon oxide films 9a is referred to as trench T1.

The manufacturing processes for this transistor will be described below.

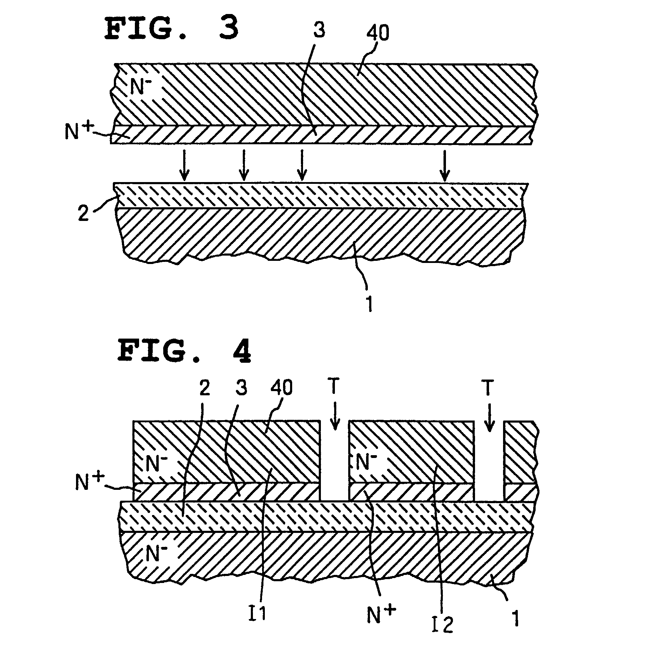

First, as illustrated in FIG. 3, the N⁻ type (100) monocrystalline silicon substrate 40 with a specific resistance of 3 - 5 Ω · cm with the N⁺ diffused layer 3 formed thereon is prepared. The bottom silicon oxide film 2 is formed over the surface of the N⁻ substrate 1 to a thickness of 1.0µm by means of thermal oxidation. The silicon substrate 1 and the silicon substrate 40 are heated in a mixed fluid of H₂O₂-H₂SO₄ for hydrophilic treatment. Then, these silicon substrates 1 and 40 are joined together at room temperature, and subjected to heat treatment in the N₂ atmosphere at 1,100°C for 2 hours for bonding.

Following the above, as illustrated in FIG. 4, the silicon substrate 40 is mirror finished to the predetermined thickness to make a silicon on insulator (SOI), and a mask oxide film for trench etching (not illustrated) is formed on the surface of the SOI. Then, the specified oxide film mask pattern is formed by the normal photolithography and a trench region T (trench T) which reaches the bottom silicon oxide film 2 is formed by dry etching. This trench T forms monocrystalline islandish semiconductor regions I1 and I2 which are three-dimensionally separated by the trench T.

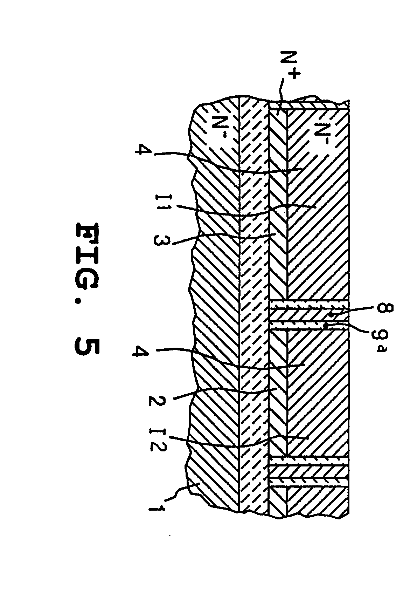

Next, as illustrated in FIG. 5, silicon oxide film (not illustrated) is formed to be 0.5 to 1 µm thick by thermal oxidation to dielectrically isolate the top and sides of the respective islandish semiconductor regions I1 and I2 for protection. Then, the trench T is filled with deposits of polysilicon. Furthermore, the islandish semiconductor regions I1 and I2 are polished until the silicon oxide film thereof is removed to smooth the surface. Finally, the side dielectric isolation regions 9a are formed to dielectrically isolate the islandish semiconductor region and the polysilicon trench filled region 8 is formed to fill the trench T between the side dielectric isolation regions 9a. At this time, the polysilicon trench filling region 8 is set to be low in donor impurity concentration.

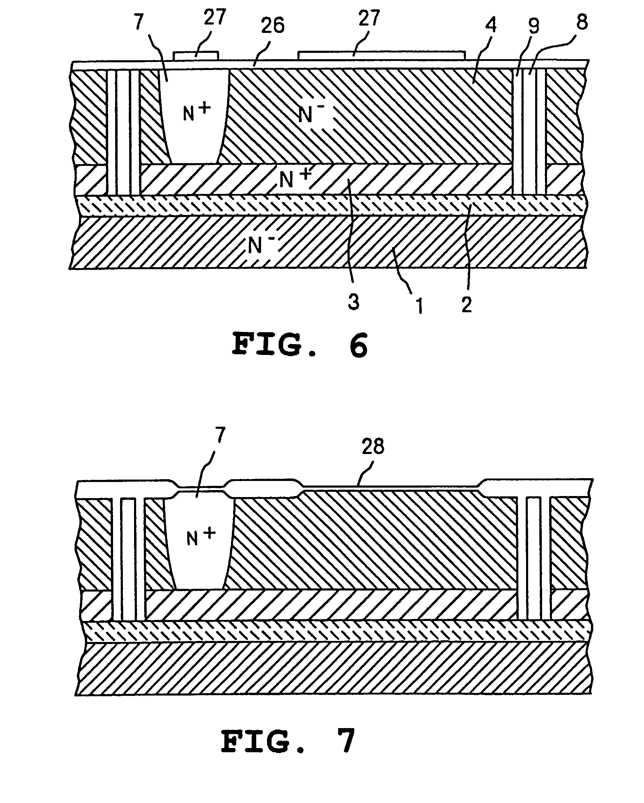

Then, the N⁺ collector contact region 7 illustrated in FIG. 6 is formed by ion-implanting and driving ions therein. A localized oxidation of silicon (LOCOS) process illustrated in FIGs. 6 and 7 follows. In this process, a silicon oxide film 26 as a pad is formed, and Si₃N₄ films 27 are formed thereon. Then, the LOCOS is performed at 1,050°C in the wet HCl atmosphere for approximately 5 hours to form a field dielectric isolation film 23 of approximately 1µm thick (FIG. 7). Successively, the Si₃N₄ films 27 and the silicon oxide film 26 as a pad are removed, and a thin silicon oxide film (430 angstrom thick) 28 is formed there instead.

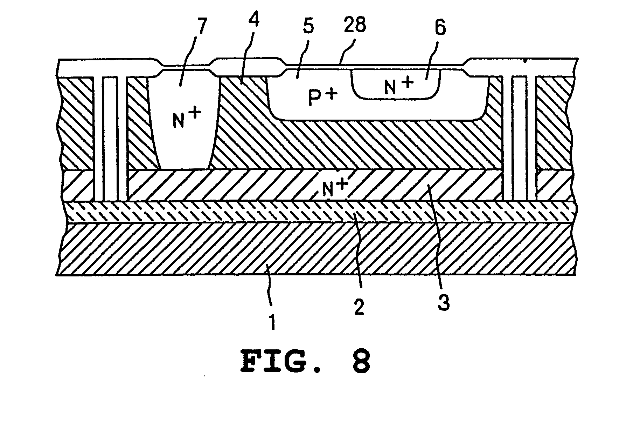

Next, as illustrated in FIG. 8, boron is ion implanted for 2.1×10¹⁴ dose/cm² at 80keV, and driven in at 1,170°C for approximately 1 hour after a photoresist mask 31 for ion-implanting is removed. Furthermore, phosphorous is ion implanted for 7.0×10¹⁵ dose/cm² at 130keV and driven in at 1,050°C for approximately 4 hours to form the P⁺ base region 5 and the N⁺ emitter region 6. The processes subsequent to this are the same as the conventional manufacturing processes, for which reason the description thereof will be omitted herein.

The important part of this embodiment will now be described in detail.

First, the parameters of the respective parts are set as follows:

The impurity concentration in the N⁻ collector withstand voltage region 4 is 1×10¹⁵ atoms/cm³, the impurity concentration in the surface of the P⁺ base region 5 is 3×10¹⁸ atoms/cm³, the impurity concentration in the surface of the N⁺ emitter region 6 is 1×10²⁰ atoms/cm³, the distance between the base region 5 on the surface of the collector withstand voltage region 4 and the side dielectric isolation region 9 is 2.5µm, and the thickness of the collector withstand voltage region 4 between the base region 5 and the buried collector region 3 is 4µm.

Next, a description will be given to voltage to be applied.

In this embodiment, 0V is applied to the circumferential semiconductor region 14 partitioned from the element region in which bipolar transistor is formed by the trench T1 and to the emitter region 6 and the maximum collector voltage (power voltage, e.g., 50V) is applied to the collector contact region 7 (i.e., buried collector region 3). Therefore, when the electric potential is 0V at the base region 5, the depletion layer of the base/collector junction may not reach the buried collector region 3 but reach the trench T1.

In other words, the low electric potential at the circumferential semiconductor region 14 exerts an electrostatic effect on the collector withstand voltage region 4 in the vicinity of the sides of the base region 5 through the trench T1 (to electrostatically lower the electric potential) and mitigate the electric field of the depletion layer of the collector withstand voltage region 4 in the vicinity of the sides of the base region 5. This mitigates the electric field of the depletion layer in the vicinity of the corner parts of the base region 5, where the electric field concentration is the most intensive and the first avalanche breakdown occurs, and improves the withstand voltage.

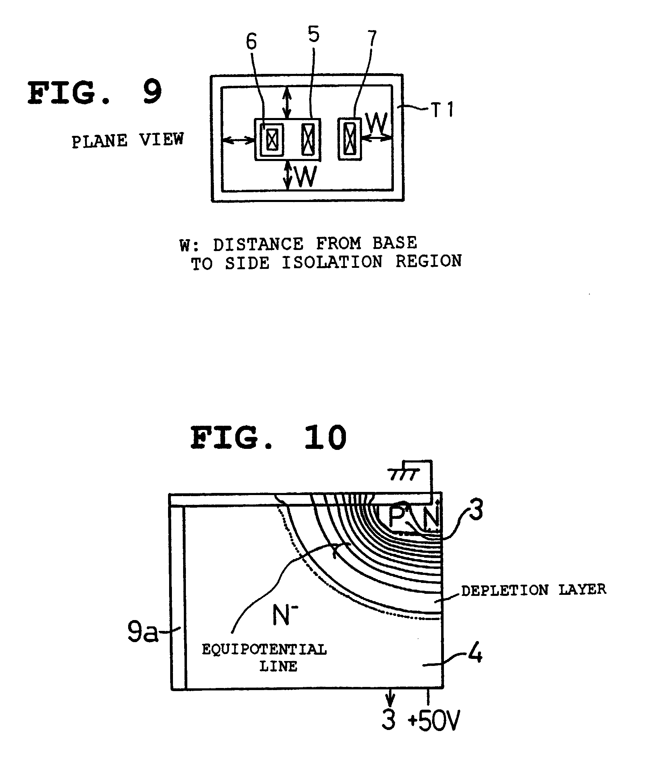

How to improve the withstand voltage by grounding the outer semiconductor region will now be described referring to a transistor model illustrated in FIG. 9 and the relation between the flat surface shape and withstand voltage of the base region 5 illustrated in FIGs. 10, 11 and 12.

The reference numbers in FIG. 9 correspond to those in FIG. 1, and the crossed regions in FIG. 9 indicate contact regions contacting with wiring layers.

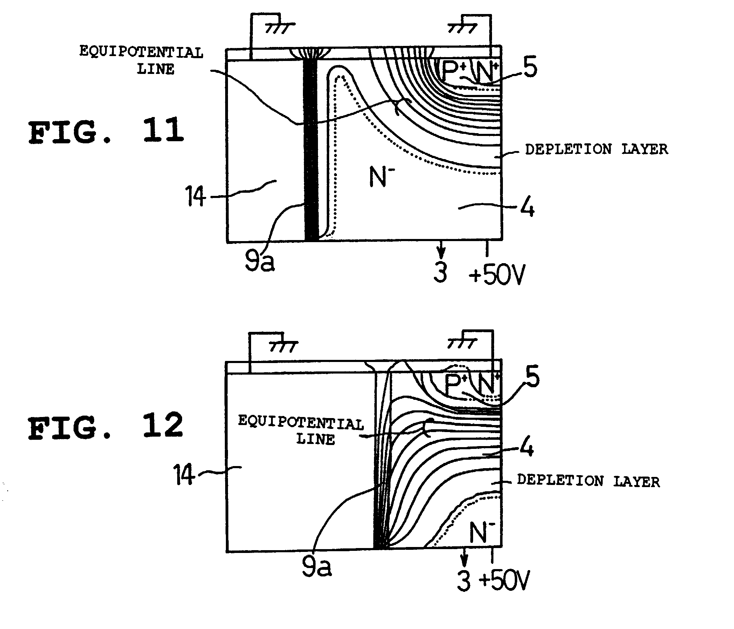

The above depletion layer shape was simulated at a base/collector voltage of 50V, and the results of this simulation are illustrated in FIGs. 10, 11 and 12. FIG. 10 shows a case where the distance between the base region 5 and the side dielectric isolation region 9 is 15µm, FIG. 11 shows a case of 10µm in that distance, and FIG. 12 shows a case of 5µm in that distance. All the other conditions are the same as the above. From FIGs. 10, 11 and 12, it is understood that when the depletion layer reaches the trench T1, the effect of the high electric potential at the buried collector region 3 is less likely to exert the effect on the corner parts of the base region 5 due to the effect of the low electric potential at the circumferential semiconductor region 14.

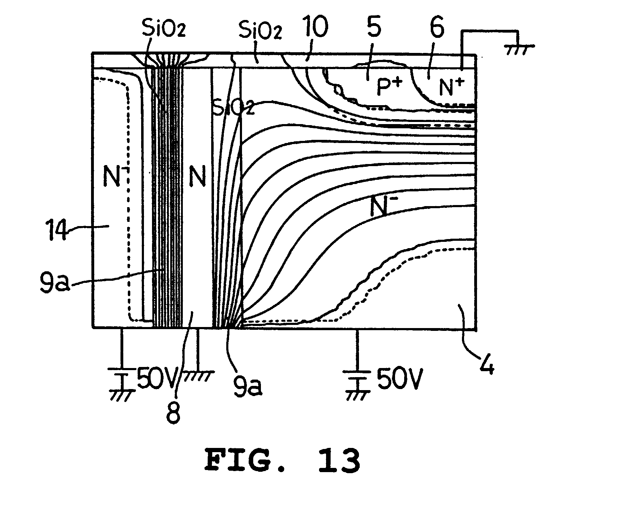

In the above embodiment, the polysilicon trench filled region 8 is made low in impurity concentration to realize a floating electric potential, and the circumferential semiconductor region 14 that is dielectrically isolated from the element region by the trench T1 is grounded. Alternatively, however, it may be arranged so that the impurity concentration of the polysilicon region 8 is raised by means of depositing or subsequent phosphorous doping during the formation thereof to be high (e.g., 10²⁰ atoms/cm³) and then this polysilicon region 8 is grounded. This case was also simulated under the conditions that the low electric potential action was the same as the above (W = 5µm) and similar transistors were formed in the outer semiconductor region 11. The results of this simulation are illustrated in FIG. 13. It is understood from FIG. 13 that there is electric field mitigating action in the same way as when the circumferential semiconductor region 14 is grounded.

In the following embodiments, either the polysilicon trench filled region 8 should be made high in impurity concentration and grounded to achieve the low electric potential state or the outer semiconductor region partitioned by the trench T1 should be grounded to achieve the low electric potential state and may be freely chosen, or both the polysilicon trench filled region 8 and the outer semiconductor region may be grounded.

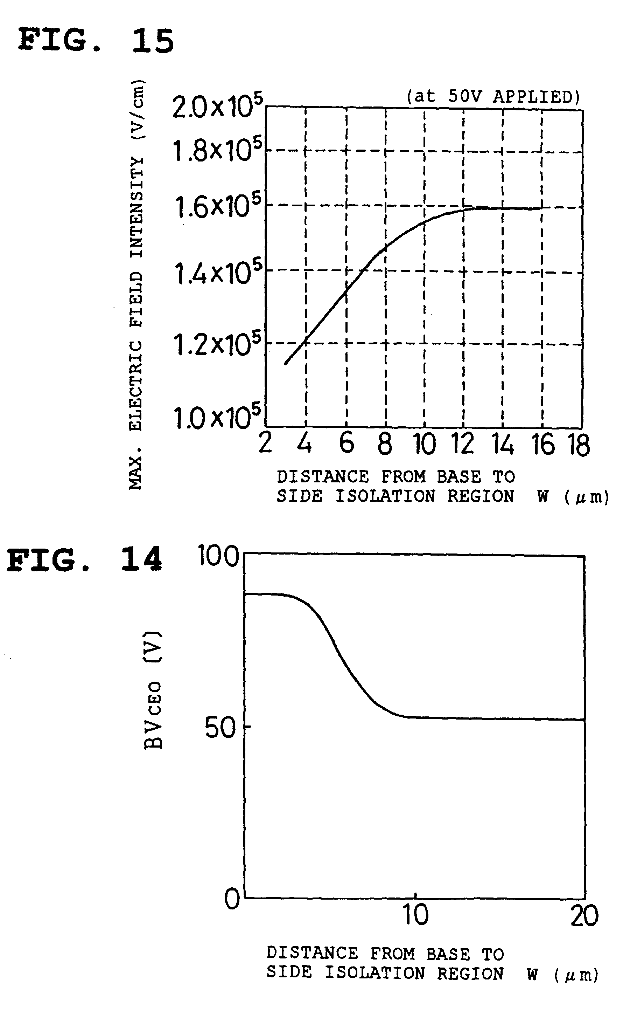

The change in the collector to emitter withstand voltage with the base in the open state BV_{CEO} was simulated with the distance W between the base region 5 and the side silicon oxide film 9a changed and all the other conditions remaining the same. The results of this simulation are illustrated in FIG. 14. The depletion layer width at this time was 9µm. It is understood from this figure that when the depletion layer reaches the side silicon oxide film 9a, BV_{CEO} can be improved.

The maximum electric field intensity of the depletion layer when the distance W between the base region 5 and the side silicon oxide film 9a is changed is illustrated in FIG. 15. It is understood from this figure that as the distance W becomes smaller, the maximum electric field intensity of the depletion layer becomes smaller.

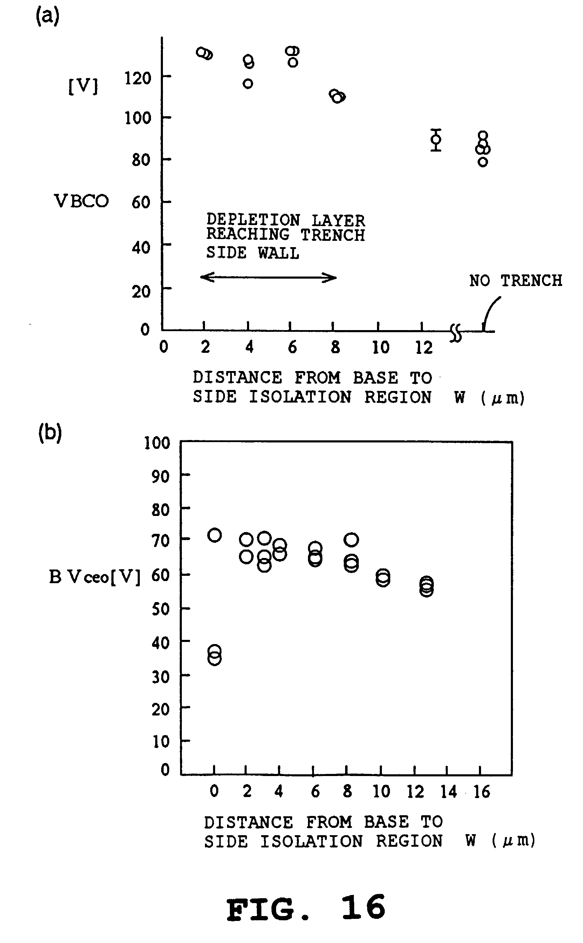

The actual measurements of the change in the collector to base withstand voltage BV_{CBO} with the emitter in the open state were simulated with the distance W between the base region 5 and the side silicon oxide film 9a changed and all the other conditions remaining the same. The measurement results of the withstand voltages are illustrated in FIGs. 16(a) and 16(b). It is understood from these figures that when the depletion layer reaches the side silicon oxide film 9a, BV_{CBO} can be improved.

In FIGs. 9 through 15 and FIGs. 16(a) and 16(b) inclusive, the distance W between the base region 5 and the side silicon oxide film 9a is the distance between the mask opening patterns. The edge of the mask opening pattern displaces by 2.5µm against the edge of the surface of the base region 5 with the side of the side silicon oxide film 9 set as positive.

Also in this embodiment, because the horizontal area of the collector withstand voltage region 4 can be reduced, the integration degree can also be improved.

Furthermore, in this embodiment, the lateral distance from the base region 5 within the collector withstand voltage region 4 to the side silicon oxide film 9 is set to be smaller than the vertical distance from the base region 5 within the collector withstand voltage region 4 to the buried collector region 3. Therefore, even when the above depletion layer reaches the side silicon oxide film 9, the depletion layer has not yet reached the buried collector region 3. For this arrangement, all the adverse effects of reaching the buried collector region 3 by the depletion layer can be avoided.

Although the above embodiment is an application of the present invention to an NPN bipolar transistor, it can easily be understood that the present invention can also be applied to other types of transistors or diodes.

### (Second Embodiment)

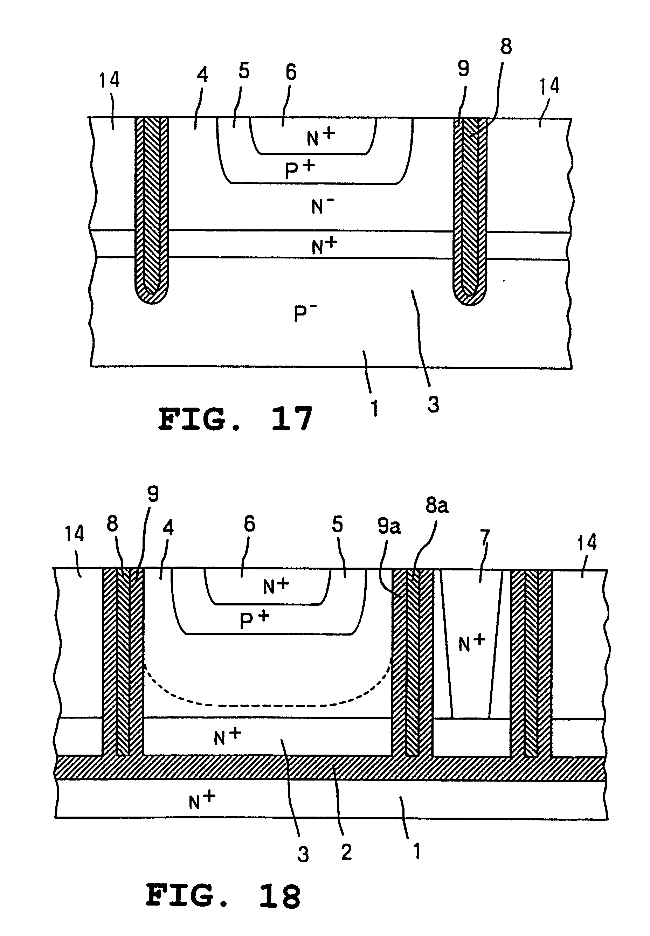

Another embodiment according to the present invention is illustrated in FIG. 17.

This embodiment is the same as the first embodiment except for that the polysilicon oxide film 2 for the bottom dielectric isolation is omitted. In this embodiment, therefore, there is no need for an SOI substrate, which simplifies the manufacturing processes. In this embodiment, either the semiconductor region outside the side dielectric isolation region 9 or the polysilicon region 8 within the side dielectric isolation region 9 may be taken as an adjacent semiconductor region.

A problem remaining unsolved with the above first and second embodiments is that, due to the formation of the N⁺ collector contact region (surface contact region) 7, the depletion layer can not reach the side silicon oxide film 8 at the side where the base region 5 faces the collector contact region 7. As a result, the withstand voltage in the vicinity of the corner parts of the base region 5 in this portion can not be improved. The measure to counter this problem will now be described referring to the following embodiments.

### (Third Embodiment)

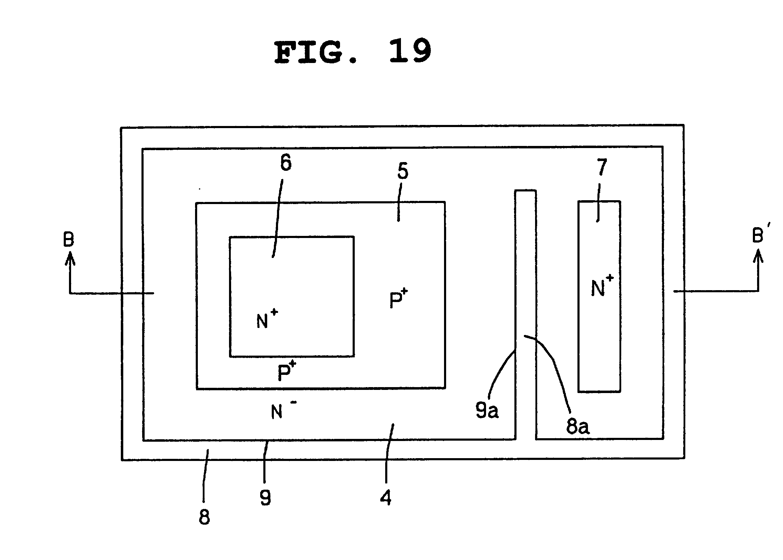

The third embodiment is illustrated in a cross-sectional view in FIG. 18 and in a plane view in FIG. 19, wherein FIG. 18 is the cross-sectional view taken along line B-B' in FIG. 19. As illustrated in these figures, the side silicon oxide film 9a and the polysilicon region 8 are disposed between the N⁺ collector contact region 7 and the base region 5 to reduce the effect of the high electric potential at the collector contact region 7 due to a trench T2 composed of a side silicon oxide film 9b and the polysilicon trench filled region 8 on the vicinity of the corner parts of the base region 5. In this embodiment, the bottom of the trench T2 is connected to the bottom silicon oxide film 2, and an end of the trench T2 is connected to the trench T1 and the other end of the trench T2 is not connected to the trench T1 but suspended.

That is, as illustrated in FIGs. 18 and 19, most parts of the side surface of the collector contact region 7 at the side of the base region 5 are bordered by the trench T2 composed of the side silicon oxide film 9a and the polysilicon region 8. Therefore, the depletion layer between the base and the collector reaches the trench T2, and the electric field can be mitigated by the effect of the low electric potential at the polysilicon area 8.

It can easily be understood that as the bottom of the N⁺ collector contact region 7 is in contact with the N⁺ buried collector region 3, the increase in collector resistance can almost be neglected.

It should be noted here that the trench T2 can be formed at the same time with the formation of the trench T1.

Modifications to the third embodiment will be described below.

### (Fourth Embodiment)

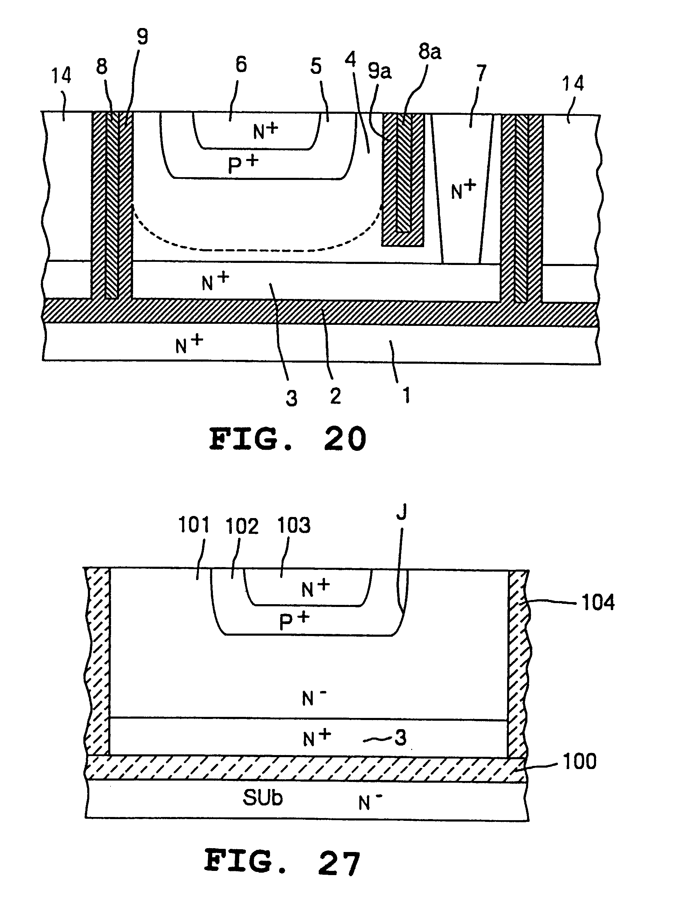

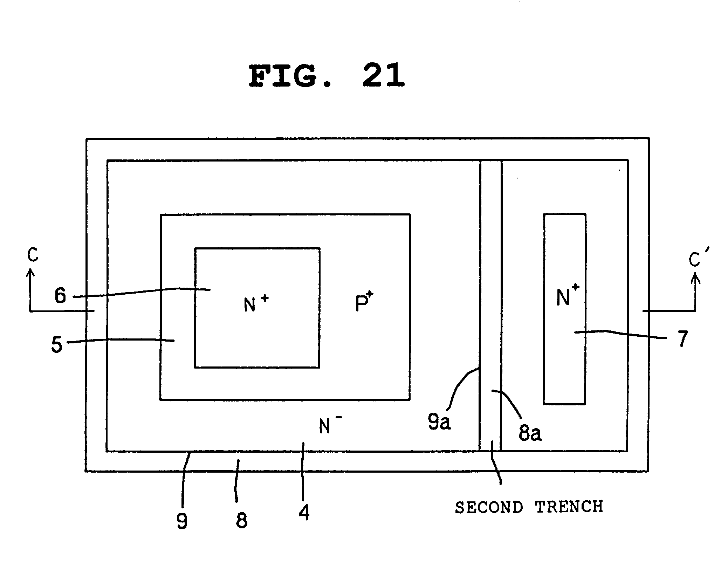

The fourth embodiment is illustrated in a cross-sectional view in FIG. 20 and in a plane view in FIG. 21, wherein FIG. 20 is the cross-sectional view taken along line C-C' in FIG. 21. As illustrated in these figures, the fourth embodiment is a modification to the third embodiment. In this embodiment, the trench T2 is disposed between the N⁺ collector contact region 7 and the base region 5 to reduce -the effect of the high electric potential at the collector contact region on the vicinity of the corner parts of the base region 5.

As it is understood from FIG. 20, the trench T2 completely isolates the N⁺ collector contact region 7 from the base region 5.

It should be noted, however, that the bottom of the trench T2 is formed shallower than the upper end of the N⁺ buried collector region 3 so as not to allow the trench T2 to cut off the N⁺ buried collector region 3.

As compared with the third embodiment, this structure can mitigate the entire electric field of the depletion layer between the base region 5 and the surface collector contact region 7, which results in the higher withstand voltage of the collector.

### (Fifth Embodiment)

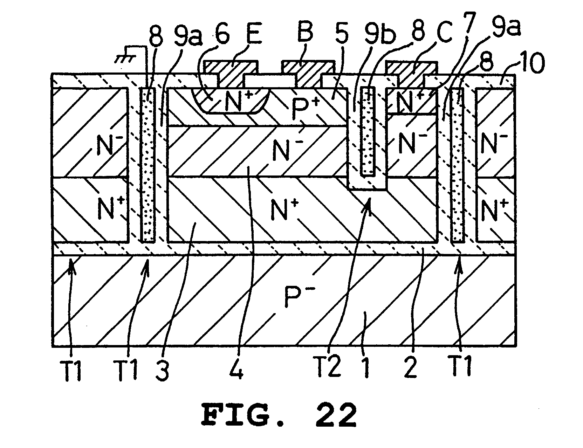

A cross-sectional view of the fifth embodiment is illustrated in FIG. 22. The trench T1 is arranged to be in contact with the base region 5 to reduce the element region and improve the withstand voltage. In this embodiment, the trench T2 is extended laterally to the trench T1, and the trench filled area 8 within the trench T2 is grounded together with the polysilicon trench filled region 8 within the trench T1.

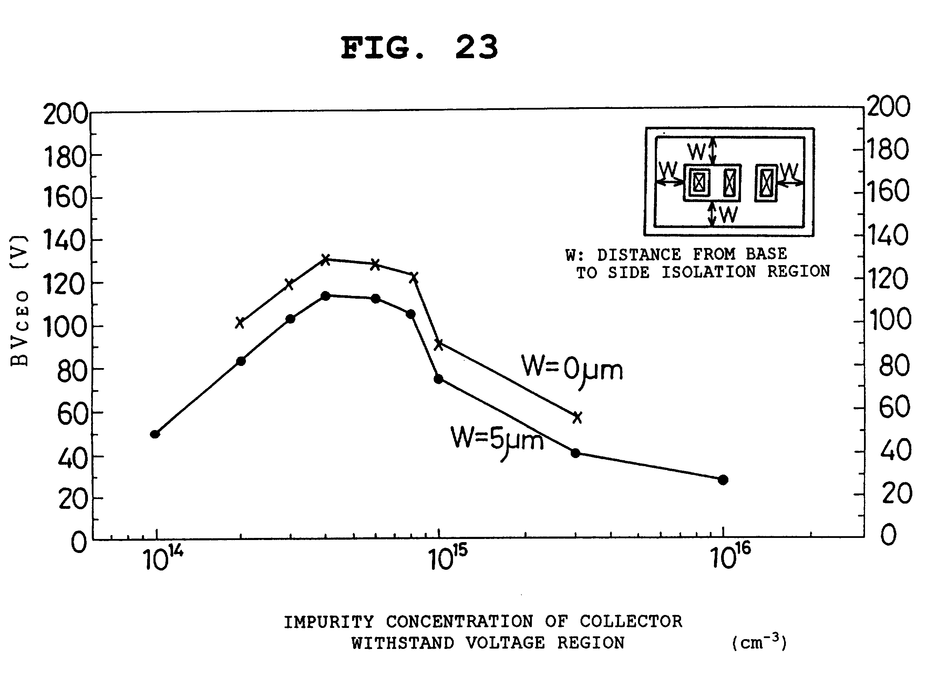

The improvement in the withstand voltage is presented in FIG. 23. The plane view of the element framed within this figure is the same as the plane view of the element in FIG. 9, and illustrates as to cases where the distances between the base region 5 and the trench T1 are 5µm and 0µm. From this figure, it is understood that when the distance between the base region 5 and the trench T1 is 0µm, the withstand voltage is higher.

In Fig. 23, "W" represents the distance from base to side isolation region.

In the foregoing five embodiments, it has been described in depth that the polysilicon trench filled region 8 within the trench T1 is electrically floated, the outside of the circumferential semiconductor region 14 or the polysilicon trench filled region 8 is grounded, and furthermore both the circumferential semiconductor region 14 and the polysilicon trench filled region 8 may be grounded. Here, a description will be given to the impurity concentration of the polysilicon trench filled region 8.

In electrically floating the polysilicon trench filled region 8, if the impurity concentration thereof is low, the polysilicon trench filled region 8 will be depleted and functions as a dielectric, and, on the other hand, if the impurity concentration thereof is high, the polysilicon trench filled region 8 will electrically leak and be susceptible to some electric potential. Therefore, in this case (the electrodes are not contacted), it is preferable that the impurity concentration of the polysilicon trench filled region 8 should be set to be low.

On the other hand, in a case where the electrodes are contacted and voltage approximate to the electric potential at the emitter is applied thereto, it is preferable that the impurity concentration should be set to such a level that there are some parts left over which are not depleted.

Care should be directed to the fact that in the third, fourth and fifth embodiments, if the polysilicon trench filled region 8 between the P⁺ base region 5 and the N⁺ surface collector region 7 (i.e., within the trench T2) is electrically floated, the depletion layer of the N⁻ collector withstand voltage region 4 beneath the P⁺ base region 5 will be bent due to the effect of the high electric potential at the N⁺ surface collector region 7, and as a result, electric field concentration will be promoted and the withstand voltage there will be degraded. Therefore, it is preferable that at least the polysilicon trench filled region 8 of the trench T2 should be set to be high in impurity concentration and settled to the grounding electric potential or any electric potential approximate to the grounding electric potential in order to shut off any electrostatic effect of the surface collector region 7.

Of course, it is acceptable that the polysilicon trench filled region 8 is depleted and the N⁻ region 11 adjacent to the silicon oxide film 9a is grounded. Even in this case, the withstand voltage can be improved in the collector withstand voltage region 4 other than the silicon oxide film 9b.

Another embodiment in which the polysilicon trench filled region 8 within the trench T2 is electrically floated and the effect of the high electric potential at the N⁺ surface collector region 7 on the collector withstand voltage region 4 beneath the P⁺ base region 5 is restrained will now be presented.

### (Sixth Embodiment)

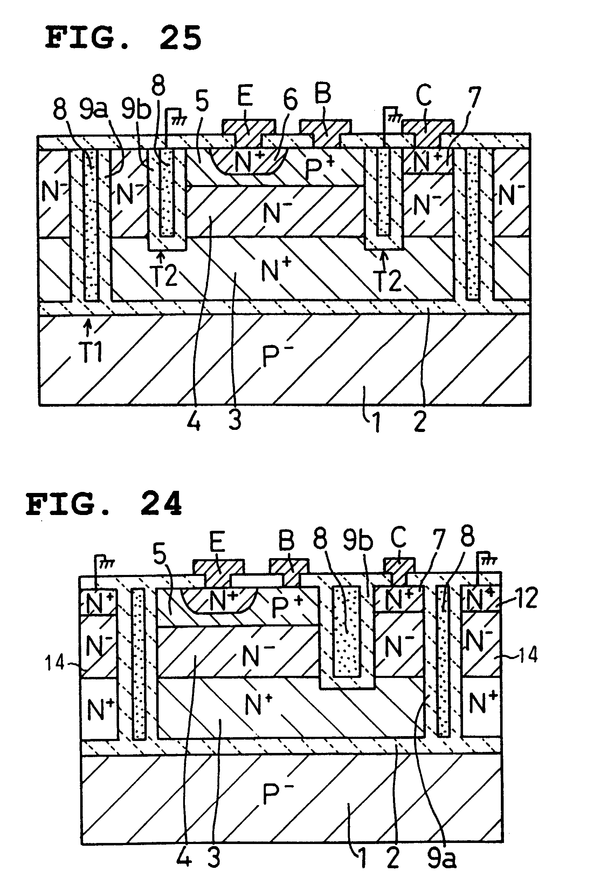

In the sixth embodiment illustrated in FIG. 24, the lateral width of the polysilicon trench filled region 8 within the trench T2 separating the base region 5 and the surface collector region 7 is set to be wider than the lateral width of the polysilicon trench filled region 8 within the trench T1.

In this arrangement, even if the polysilicon trench filled region 8 within the trench T2 is set to be low in impurity concentration to achieve a floating electric potential, the high electric potential at the surface collector region 7 will less easily affect the collector withstand voltage region 4 beneath the base region 5, and as a result, the bending of the depletion layer of the collector withstand voltage region 4 can be reduced and the withstand voltage can be improved.

Furthermore, in the foregoing third, fourth, fifth and sixth embodiments, the impurity concentration of the polysilicon trench filled region 8 within the trench T1 is set to be the same as that of the polysilicon trench filled region 8 within the trench T2. However, the impurity concentration may be set to be different therebetween. For example, only the polysilicon trench filled region 8 within the trench T2 is set to be high in impurity concentration and to the ground electric potential, while the polysilicon trench filled region 8 within the trench T1 may be set to be low in impurity concentration and the N⁻ region 11 outside the trench T1 may be grounded. This will be embodied as the seventh embodiment as described below.

### (Seventh Embodiment)

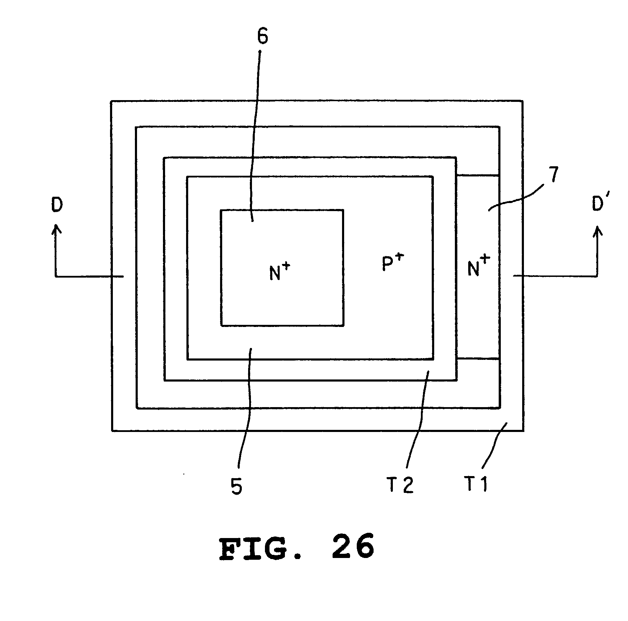

The seventh embodiment is illustrated in a cross-sectional view in FIG. 25 and in a plane view in FIG. 26, wherein FIG. 25 is a cross-sectional view taken along line D-D' in FIG. 26. As illustrated in these figures, the P⁺ base region 5 is completely surrounded by the trench T2, i.e., the silicon oxide film 9b, and the polysilicon trench filled region 8 within the trench T2 is set to be high in impurity concentration and grounded. In this arrangement, the polysilicon trench filled region 8 within the trench T1 can be set to be low in impurity concentration, the collector parasitic capacity of the transistor can be reduced, and as a result, the frequency characteristics (operation speed) can be improved while the withstand voltage can be lowered and the size can be reduced.

It is of course that the foregoing embodiments, in which only one bipolar transistor has been presented, can be applied to other transistors or diodes, and also can be applied to the integration of this bipolar transistor with a CMOS, a lateral PNP bipolar transistor, an IIL, etc.

### INDUSTRIAL APPLICABILITY

A semiconductor device which is dielectrically isolated at least at the sides according to the present invention can be applied to, for example, a high withstand voltage bipolar transistor (BPT), a high withstand voltage PN junction SIT, a high withstand voltage vertical MIS transistor, etc.

## Claims

1. Semiconductor device comprising:
a semiconductor layer (3, 4) of a first conductivity type formed over a substrate (1), said semiconductor layer being electrically isolated from said substrate;
an island-shaped semiconductor region (5) of a second conductivity type formed in a surface of said semiconductor layer, said island-shaped semiconductor region having a first impurity concentration which is higher than a second impurity concentration of said semiconductor layer, whereby a pn junction is defined between said semiconductor layer and said island-shaped semiconductor region;
a side dielectric isolation region (9a) formed in said surface of said semiconductor layer, said side dielectric isolation region being formed deeper into said semiconductor layer than said island-shaped semiconductor region to thereby bound an element region including said island-shaped semiconductor region; and
an adjacent semiconductor region (8, 14) disposed adjacent to said element region with said side dielectric isolation region disposed therebetween;
wherein said pn junction is separated from said side dielectric isolation region by a first lateral distance (W), and a reverse bias is applied to said pn junction by applying a first electric potential to said island-shaped semiconductor region and a second electric potential to said semiconductor layer, causing a depletion layer to extend through said semiconductor layer from said pn junction to said side dielectric isolation region;
whereby an electric potential that is more approximate to said first potential than to said second potential is applied to said adjacent semiconductor region (8, 14) whereby said electric potential of said adjacent semiconductor region (8, 14) acts electrostatically on said depletion layer, such that said depletion layer is deformed to increase a voltage at which said pn junction breaks down.

2. The semiconductor device according to claim 1, wherein
said semiconductor layer (3, 4) comprises a high impurity concentration layer (3) and a low impurity concentration layer (4) formed thereon, wherein said island-shaped semiconductor region (5) is formed in said low impurity concentration layer, and wherein the first lateral distance from said island-shaped semiconductor region within said element region to said side dielectric isolation region (9a) is set to be smaller than the vertical distance from said island-shaped semiconductor region to said high impurity concentration layer.

3. Semiconductor device according to claim 2, further comprising:
a bottom dielectric isolation region (2) between said substrate and said semiconductor layer, wherein
said side dielectric isolation region (9a) is formed so as to reach said bottom dielectric isolation region.

4. Semiconductor device according to claim 3, wherein:
said adjacent semiconductor region (8, 14) comprises a polysilicon region (8) of a high impurity concentration filled within said side dielectric isolation region (9a).

5. The semiconductor device according to any one of claims 1 to 4, wherein
a surface contact region (7) which is of the same conduction type as said semiconductor layer (3, 4) and higher in impurity concentration than said semiconductor layer is so formed as to be in separation from said island-shaped semiconductor region within said element region;
a dielectric isolation wall (9a) is provided between said surface contact region and said island-shaped semiconductor region (5), such that the depletion layer of said pn junction reaches the dielectric isolation wall (9a) where the surface contact region (7) faces the island-shaped semiconductor region.

6. Semiconductor device according to claim 5 when dependent on claim 3, further comprising:
said dielectric isolation wall being connected to the bottom dielectric isolation region (2), thereby dividing said semiconductor layer within said element region into a first region including said island-shaped semiconductor region and a second region including said surface contact region, said dielectric isolation wall allowing communication between said first region and said second region through a contiguous portion of said semiconductor layer between a side end of said dielectric isolation wall and said side dielectric isolation region.

7. Semiconductor device according to claim 2 or 3, further comprising:
said dielectric isolation wall dividing said semiconductor layer within said element region into a first region including said island-shaped semiconductor region and a second region including said surface contact region, said dielectric isolation wall allowing communication between said first region and said second region through a contiguous portion of said semiconductor layer (3, 4) passing under said dielectric isolation wall.

8. Semiconductor device according to claim 3, wherein said adjacent semiconductor region (8, 14) includes:
a second high impurity concentration layer (3); and
a second low impurity concentration layer (14) disposed on said second high impurity concentration layer.

9. Semiconductor device according to any one of claims 1 to 4 and 8, wherein:
said adjacent electric potential is a ground potential.

10. Semiconductor device according to any one of claims 1 to 4 and 8 or 9, wherein
a LOCOS oxide film (28) is formed on the surface of the semiconductor layer; and
said island-shaped semiconductor region (5) has a diffusion depth deeper than a bottom of said LOCOS oxide film.

## Patentansprüche

1. Halbleiteranordnung mit:
einer Halbleiterschicht (3, 4) eines ersten Leitfähigkeitstyps, welche über einem Substrat (1) gebildet ist, wobei die Halbleiterschicht von dem Substrat elektrisch isoliert ist;
einem inselförmigen Halbleitergebiet (5) eines zweiten Leitfähigkeitstyps, welches in einer Oberfläche der Halbleiterschicht gebildet ist, wobei das inselförmige Halbleitergebiet eine erste Störstellenkonzentration aufweist, welche größer als eine zweite Störstellenkonzentration der Halbleiterschicht ist, wodurch ein pn-Übergang zwischen der Halbleiterschicht und dem inselförmigen Halbleitergebiet definiert wird;
einem dielektrischen Seitenisolierungsgebiet (9a), welches in der Oberfläche der Halbleiterschicht gebildet ist, wobei das dielektrische Seitenisolierungsgebiet tiefer in die Halbleiterschicht eingebracht ist als das inselförmige Halbleitergebiet, um dadurch ein Elementegebiet einzugrenzen, welches das inselförmige Halbleitergebiet enthält; und
einem benachbarten Halbleitergebiet (8, 14), welches an das Elementegebiet angrenzend angeordnet ist, wobei das dielektrische Seitenisolierungsgebiet dazwischen angeordnet ist;
wobei der pn-Übergang von dem dielektrischen Seitenisolierungsgebiet um einen ersten seitlichen Abstand (W) getrennt ist und eine Sperrvorspannung an den pn-Übergang durch Anlegen eines ersten elektrischen Potentials an das inselförmige Halbleitergebiet und eines zweiten elektrischen Potentials an die Halbleiterschicht angelegt wird, wodurch eine Verarmungsschicht hervorgerufen wird, welche sich durch die Halbleiterschicht von dem pn-Übergang bis zu dem dielektrischen Seitenisolierungsgebiet erstreckt;
wodurch ein elektrisches Potential, welches mehr an das erste Potential als an das zweite Potential angenähert ist, an das angrenzende Halbleitergebiet (8, 14) angelegt wird, wodurch das elektrische Potential des angrenzenden Halbleitergebietes (8, 14) elektrostatisch auf die Verarmungsschicht einwirkt, so daß die Verarmungsschicht deformiert wird, um eine Spannung zu erhöhen, bei welcher der pn-Übergang zusammenbricht.

2. Halbleiteranordnung nach Anspruch 1, dadurch gekennzeichnet, daß
die Halbleiterschicht (3, 4) eine Schicht (3) mit hoher Störstellenkonzentration und eine darauf gebildete Schicht (4) mit niedriger Störstellenkonzentration aufweist, wobei das inselförmige Halbleitergebiet (5) in der Schicht mit niedriger Störstellenkonzentration gebildet ist und der erste seitliche Abstand von dem inselförmigen Halbleitergebiet innerhalb des Elementegebiets zu dem dielektrischen Seitenisolierungsgebiet (9a) auf einen kleineren Wert festgelegt ist als der vertikale Abstand von dem inselförmigen Halbleitergebiet zu der Schicht mit hoher Störstellenkonzentration.

3. Halbleiteranordnung nach Anspruch 2, des weiteren gekennzeichnet durch:
ein dielektrisches Bodenisolierungsgebiet (2) zwischen dem Substrat und der Halbleiterschicht, wobei
das dielektrische Seitenisolierungsgebiet (9a) derart gebildet ist, daß es das dielektrische Bodenisolierungsgebiet erreicht.

4. Halbleiteranordnung nach Anspruch 3, dadurch gekennzeichnet, daß
das angrenzende Halbleitergebiet (8, 14) ein Polysiliziumgebiet (8) mit einer hohen Störstellenkonzentration aufweist, welches in das dielektrische Seitenisolierungsgebiet (9a) gefüllt ist.

5. Halbleiteranordnung nach einem der Ansprüche 1 bis 4, dadurch gekennzeichnet, daß
ein Oberflächenkontaktgebiet (7), welches vom selben Leitfähigkeitstyp wie die Halbleiterschicht (3, 4) ist und eine höhere Störstellenkonzentration als die Halbleiterschicht aufweist, getrennt von dem inselförmigen Halbleitergebiet innerhalb des Elementegebiets gebildet ist;
eine dielektrische Isolierungswand (9a) zwischen dem Oberflächenkontaktgebiet und dem inselförmigen Halbleitergebiet (5) vorgesehen ist, so daß die Verarmungsschicht des pn-Übergangs die dielektrische Isolierungswand (9a) erreicht, wo das Oberflächenkontaktgebiet (7) dem inselförmigen Halbleitergebiet gegenüberliegt.

6. Halbleiteranordnung nach Anspruch 5 in Abhängigkeit von Anspruch 3, des weiteren dadurch gekennzeichnet, daß
die dielektrische Isolierungswand mit dem dielektrischen Bodenisolierungsgebiet (2) verbunden ist, wodurch die Halbleiterschicht innerhalb des Elementegebiets in ein erstes Gebiet, welches das inselförmige Halbleitergebiet enthält, und ein zweites Halbleitergebiet geteilt wird, welches das Oberflächenkontaktgebiet enthält, wobei die dielektrische Isolierungswand eine Kommunikation zwischen dem ersten Gebiet und dem zweiten Gebiet durch einen angrenzenden Teil der Halbleiterschicht zwischen einem Seitenende der dielektrischen Isolierungswand und dem dielektrischen Seitenisolierungsgebiet gestattet.

7. Halbleiteranordnung nach Anspruch 2 oder 3, des weiteren dadurch gekennzeichnet, daß
die dielektrische Isolierungswand die Halbleiterschicht innerhalb des Elementegebiets in ein erstes Gebiet, welches das inselförmige Halbleitergebiet enthält, und ein zweites Gebiet teilt, welches das Oberflächenkontaktgebiet enthält, wobei die dielektrische Isolierungswand eine Kommunikation zwischen dem ersten Gebiet und dem zweiten Gebiet durch einen angrenzenden Teil der Halbleiterschicht (3, 4) gestattet, welcher unter der dielektrischen Isolierungswand verläuft.

8. Halbleiteranordnung nach Anspruch 3, dadurch gekennzeichnet, daß das angrenzende Halbleitergebiet (8, 14)
eine zweite Schicht (3) mit hoher Störstellenkonzentration; und
eine zweite Schicht (14) mit niedriger Störstellenkonzentration enthält, welche auf der zweiten Schicht mit hoher Störstellenkonzentration angeordnet ist.

9. Halbleiteranordnung nach einem der Ansprüche 1 bis 4 und 8, dadurch gekennzeichnet, daß
das angrenzende elektrische Potential ein Massepotential ist.

10. Halbleiteranordnung nach einem der Ansprüche 1 bis 4 und 8 oder 9, dadurch gekennzeichnet, daß
eine LOCOS-Oxidschicht (28) auf der Oberfläche der Halbleiterschicht gebildet ist; und
das inselförmige Halbleitergebiet (5) eine Diffusionstiefe besitzt, welche tiefer als eine Unterseite der LOCOS-Oxidschicht ist.

## Revendications

1. Dispositif à semi-conducteur comprenant :
une couche semi-conductrice (3,4) d'un premier type de conductivité formée sur un substrat (1), ladite couche semi-conductrice étant électriquement isolée dudit substrat ;
une région semi-conductrice en forme d'îlot (5) d'un second type de conductivité formée dans une surface de ladite couche semi-conductrice, ladite région semi-conductrice en forme d'îlot ayant une première concentration d'impureté qui est plus grande qu'une seconde concentration d'impureté de ladite couche semi-conductrice, d'où il résulte qu'une jonction pn est définie entre ladite couche semi-conductrice et ladite région semi-conductrice en forme d'îlot ;
une région d'isolement diélectrique latérale (9a) formée dans ladite surface de ladite couche semi-conductrice, ladite région d'isolement diélectrique latérale étant formée plus profonde dans ladite couche semi-conductrice que ladite région semi-conductrice en forme d'îlot pour relier de ce fait une région d'élément incluant ladite région semi-conductrice en forme d'îlot ; et
une région semi-conductrice adjacente (8,14) disposée adjacente à ladite région d'élément, ladite région d'isolement diélectrique latérale étant disposée entre celles-ci ;
dans lequel ladite jonction pn est séparée de ladite région d'isolement diélectrique latérale sur une première distance latérale (W), et une polarisation inverse est appliquée à ladite jonction pn en appliquant un premier potentiel électrique à ladite région semi-conductrice en forme d'îlot et un second potentiel à ladite couche semi-conductrice, amenant une couche d'appauvrissement à s'étendre à travers ladite couche semi-conductrice à partir de ladite jonction pn jusqu'à ladite région d'isolement diélectrique latérale ;
d'où il résulte qu'un potentiel électrique qui est plus proche dudit premier potentiel que dudit second potentiel est appliqué à ladite région semi-conductrice adjacente (8,14) avec pour effet que ledit potentiel électrique de ladite région semi-conductrice adjacente (8,14) agit électrostatiquement sur ladite couche d'appauvrissement, de sorte que ladite couche d'appauvrissement est déformée pour accroître une tension à laquelle ladite jonction pn claque.

2. Dispositif à semi-conducteur selon la revendication 1, dans lequel :
ladite couche semi-conductrice (3,4) comprend une couche à concentration d'impureté élevée (3) et une couche à faible concentration d'impureté (4) formée sur celle-ci, dans lequel ladite région semi-conductrice en forme d'îlot (5) est formée dans ladite couche à faible concentration d'impureté, et dans lequel la première distance latérale à partir de ladite région semi-conductrice en forme d'îlot à l'intérieur de ladite région d'élément jusqu'à ladite région d'isolement diélectrique latérale (9a) est établie pour être plus petite que la distance verticale allant de ladite région semi-conductrice en forme d'îlot jusqu'à ladite couche à concentration d'impureté élevée.

3. Dispositif à semi-conducteur selon la revendication 2, comprenant en outre :
une région d'isolement diélectrique inférieure (2) située entre ledit substrat et ladite couche semi-conductrice, dans lequel
ladite région d'isolement diélectrique latérale (9a) est formée de façon à atteindre ladite région d'isolement diélectrique inférieure.

4. Dispositif à semi-conducteur selon la revendication 3, dans lequel :
ladite région semi-conductrice adjacente (8,14) comprend une région de polysilicium (8) d'une concentration d'impureté élevée placée à l'intérieur de ladite région d'isolement diélectrique latérale (9a).

5. Dispositif à semi-conducteur selon l'une quelconque des revendications 1 à 4, dans lequel :
une région de contact de surface (7) qui est du même type de conductivité que ladite couche semi-conductrice (3,4) et d'une concentration d'impureté plus élevée que ladite couche semi-conductrice est formée de manière à être séparée de ladite région semi-conductrice en forme d'îlot à l'intérieur de ladite région d'élément ;
une paroi d'isolement diélectrique (9a) est prévue entre ladite région de contact de surface et ladite région semi-conductrice en forme d'îlot (5), de sorte que la couche d'appauvrissement de ladite jonction pn atteint la paroi d'isolement diélectrique (9a) où la région de contact de surface (7) est en regard de la région semi-conductrice en forme d'îlot.

6. Dispositif à semi-conducteur selon la revendication 5 lorsque dépendante de la revendication 3, comprenant en outre :
ladite paroi d'isolement diélectrique étant connectée à ladite région d'isolement diélectrique inférieure (2), divisant de ce fait ladite couche semi-conductrice à l'intérieur de ladite région d'élément en une première région incluant ladite région semi-conductrice en forme d'îlot et une seconde région incluant ladite région de contact de surface, ladite paroi d'isolement diélectrique permettant la communication entre ladite première région et ladite seconde région à travers une partie contiguë de ladite couche semi-conductrice entre une extrémité latérale de ladite paroi d'isolement diélectrique et ladite région d'isolement diélectrique latérale.

7. Dispositif à semi-conducteur selon la revendication 2 où 3, comprenant en outre :
ladite paroi d'isolement diélectrique divisant ladite couche semi-conductrice à l'intérieur de ladite région d'élément en une première région incluant ladite région semi-conductrice en forme d'îlot et une seconde région incluant ladite région de contact de surface, ladite paroi d'isolement diélectrique permettant la communication entre ladite première région et ladite seconde région à travers une partie contiguë de ladite couche semi-conductrice (3,4) passant sous ladite paroi d'isolement diélectrique.

8. Dispositif à semi-conducteur selon la revendication 3, dans lequel ladite région semi-conductrice adjacente (8,14) inclut :
une seconde couche à concentration d'impureté élevée (3) ; et
une seconde couche à faible concentration d'impureté (14) disposée sur ladite seconde couche à concentration d'impureté élevée.

9. Dispositif à semi-conducteur selon l'une quelconque des revendications 1 à 4 et 8, dans lequel :
ledit potentiel électrique adjacent est un potentiel de masse.

10. Dispositif à semi-conducteur selon l'une quelconque des revendications 1 à 4 et 8 ou 9, dans lequel :
un film d'oxyde LOCOS (28) est formé sur la surface de la couche semi-conductrice ; et
ladite région semi-conductrice en forme d'îlot (5) a une profondeur de diffusion plus profonde qu'un fond dudit film d'oxyde LOCOS.
